# EUROPEAN PATENT APPLICATION

(11) **EP 1 964 942 A1**
(43) Date of publication of application: **03.09.2008**
(21) Application number: 08003564.5
(22) Date of filing: 27.02.2008
(51) Int. Cl.: C23C 14/20, B65D 81/34

(54) **Container for food use**

(30) Priority: 28.02.2007 IT GE20070021
(71) Applicant: Nantech S.r.l., 19020 Ceparana di Bolano (SP) (IT)
(72) Inventor: Rodolfo Candelo, I-19020 Ceparana di Bolano (SP) (IT)
(74) Representative: Pennacino, Enrico

(57) **Abstract**

A container made of plastic material, particularly for food, cosmetic or pharmaceutical use, wherein an outer surface thereof has a coating which is preferably very small in thickness, said coating being produced by sputtering deposition of a metallic material.

## Description

The present invention relates to containers made of plastic material, and particularly it relates to containers made of plastic material for food, cosmetic or pharmaceutical use.

One widely recognized problem connected with plastic containers is that, while being undoubtedly versatile and offering an extreme ease of production, they do not always provide optimal conservation characteristics for the products they are intended to store. In particular, the gas permeability and transparency to UV radiation allow for a range of decay processes to take place; furthermore, the proliferation of bacterial populations within the container is enhanced, hence increasing a risk of effective decay of its content, especially in the case of food products.

To avoid the problem of transparency, until now pigments and/or colorants, capable of absorbing the frequencies that would be the most harmful to the packaged products, have been included in the formulations of the thermoplastic resins used to manufacture the containers; however, these additives are often characterized by toxicity levels that are quite high.

Accordingly, the aim of the present invention is to provide a container made of plastic material, particularly for food, cosmetic or pharmaceutical use, which can exhibit some non-permeability generally to gases, and particularly to oxygen.

The Applicant is already owner of the Italian Patent Application No. GE2005A000003, which discloses a coating apparatus using vacuum deposition techniques for metals and other materials. In particular, the research that led to the present invention has investigated the efficiency of the deposition of extremely thin layers (edging towards the monomolecular layer) of a metallic material in improving the non-permeability to gases and the non-transparency to certain radiations.

Accordingly, the object of the present invention is a container made of plastic material, particularly for food, cosmetic or pharmaceutical use, wherein an outer surface thereof has a coating which is preferably very small in thickness, said coating being produced by sputtering deposition of a metallic material.

The metallic material can be a pure metal or a metal alloy, with the preferred pure metals being Ti and Ag, and with the preferred metal alloys being brass alloys substantially comprising Cu and Zn, in which Zn is from 11 to 50 wt%.

Preferably, the thickness of the coating is in the range from 20 to 700 nm; a coating with a thickness less than 20 nm is substantially transparent, and so it cannot effectively perform its function, while a coating with a thickness more than 700 nm has deposition times which adversely affect the whole process economy. Particularly, a coating having a thickness in the range from 100 to 400 nm, preferably from 200 to 300 nm, can achieve the best results in terms of protection efficiency, and it can be made with the lowest cost and the fastest time.

Other advantages and features will be apparent from the following use example of a container according to the present invention.

### Example

Containers (especially bottles) of polyethylene terephthalate were made and coated with metallic materials according to the present invention, and their ability to protect their content was evaluated. The test was run on seven bottles, two of which were coated with Ag, two with Ti, two with brass, and one of which was kept uncoated as a reference sample. The average thickness of the coatings was in the range from 150 to 300 nm.

All the bottles were washed with distilled water and hence filled with pasteurized milk, then left to stand at an average temperature of 21°C under artificial lighting for two days.

The content was then subject to microbiological analysis to measure the total bacteria count, the total coliform count, and the counts of *Staphylococcus aureus* (coagulase-positive), *Staphylococcus* (coagulase-negative) and *Escherichia coli,* according to standard analytical methods commonly used in measuring these values.

The results of this microbiological analysis are reported in Table 1.

**Table 1**

| Sample | Total bacteria count | Total coliform count | *Staphylococcus aureus* (coagulase+) | *Staphylococcus* (coagulase-) | *E. Coli* |
|---|---|---|---|---|---|
| (coating) | (c/ml) | (c/ml) | (c/ml) | (c/ml) | (c/m) |
| Ti | >10⁵ | < 10 | 30 | > 10³ | 0 |
| Ti | >10⁵ | N.E.(*) | N.E. (§) | >5x10³ | 0 |
| Ag | >10⁵ | >10³ | N.D. | >10³ | 2 |
| Ag | >10⁵ | <10 | N.E. (§) | >5x10³ | 0 |
| brass | >10⁵ | 110 | N.D. | >10³ | 0 |
| brass | >10⁵ | <10 | N.D. | >10³ | 0 |
| - | >10⁵ | N.E.(*) | N.E. (§) | >10⁴ | 5 |

| | | | | | |
|---|---|---|---|---|---|
| N.E.(*): not evaluable; the plates did not show the growth of coliforms, but rather of non-lactose fermenting enterobacteria. N.E. (§): not evaluable; the high growth of Staphylococcus did not allow the identification of coagulase-positive colonies. N.D.: not detectable. | | | | | |

From the above data, the container according to the present invention shows a generally effective behaviour in protecting perishable products introduced therein. The choice of milk as the product to be analysed is mainly dictated by its relatively short decay time, and hence by the quickness of the analytical results. The results achieved by both brass-coated samples should be particularly highlighted, as they show the greatest difference from the results of the uncoated reference sample.

The resulting container offers numerous advantages in terms of preservation of perishable products, as it appears to be able to provide a noticeable protection from both the penetration of gases into the container and the light; Furthermore, the deposition of metallic materials in such thin layers does not impede recycling of the containers according to the invention, as the proportion of added coating mass to the whole container mass is very limited if not irrelevant.

## Claims

1. A container made of plastic material, particularly for food, cosmetic or pharmaceutical use, wherein an outer surface thereof has a coating which is preferably very small in thickness, said coating being produced by sputtering deposition of a metallic material.

2. A container according to Claim 1, wherein the metallic material comprises a pure metal.

3. A container according to Claim 1, wherein the metallic material comprises a metal alloy.

4. A container according to Claim 2, wherein said metal is selected from the group consisting of Ti and Ag.

5. A container according to Claim 3, wherein said metal alloy is a brass alloy substantially comprising Cu and Zn, in which Zn is from 11 to 50 wt%.

6. A container according to any one of the preceding Claims 1 to 5, wherein the thickness of the coating is in the range from 20 to 700 nm.

7. A container according to Claim 6, wherein the coating is from 100 to 400 nm in thickness, preferably from 200 to 300 nm in thickness.
